# EUROPÄISCHE PATENTSCHRIFT

(11) **EP 2 385 381 B1**
(45) Veröffentlichungstag und Bekanntmachung des Hinweises auf die Patenterteilung: **06.06.2018**
(21) Anmeldenummer: 11164096.7
(22) Anmeldetag: 28.04.2011
(51) Int. Cl.: G01R 27/16, H02J 3/38

(54) **Vorrichtung zur Messung der Netzimpedanz eines elektrischen Versorgungsnetzes**
Device for measuring the network impedance of an electric supply network
Dispositif de mesure de l'impédance d'un réseau d'alimentation électrique

(30) Priorität: 03.05.2010 DE 102010018996
(43) Veröffentlichungstag der Anmeldung: 09.11.2011
(73) Patentinhaber: Helmut-Schmidt-Universität/ Universität der Bundeswehr Hamburg, 22043 Hamburg (DE); Hamburg Innovation GmbH, 21079 Hamburg (DE)
(72) Erfinder: Do Thanh, Trung, 22043 Hamburg (DE); Schulz, Detlef, 22043 Hamburg (DE); Langkowski, Hauke, 22043 Hamburg (DE); Jordan, Michael, 22043 Hamburg (DE)
(74) Vertreter: Maiwald Patent- und Rechtsanwaltsgesellschaft mbH

(56) Entgegenhaltungen:
- EP-A1- 1 916 530
- DE-A1-102004 059 100
- US-A1- 2003 164 695
- US-A1- 2008 036 472
- HAUKE LANGKOWSKI ET AL: "Grid impedance determination â relevancy for grid integration of renewable energy systems", IECON 2009 - 35TH ANNUAL CONFERENCE OF IEEE INDUSTRIAL ELECTRONICS (IECON 2009) - 3-5 NOV. 2009 - PORTO, PORTUGAL, IEEE, PISCATAWAY, NJ, USA, 3. November 2009 (2009-11-03), Seiten 516-521, XP031629625, ISBN: 978-1-4244-4648-3
- HAAG Elektronische Messgeräte GmbH: "Datenblatt EWS 120 Netzimpedanz Messgerät", , 20. Juni 2007 (2007-06-20), XP002725605, Gefunden im Internet: URL:http://haag-messgeraete.de/cms/upload/ pdf/EWS120_prospekt.pdf [gefunden am 2014-06-11] -& HAAG Elektronische Messgeräte GmbH: "Prospekt EWS 120 Netzimpedanz Messgerät", , 20. Juni 2007 (2007-06-20), XP002725606, Gefunden im Internet: URL:https://web.archive.org/web/*/http://h aag-messgeraete.de/cms/front_content.php?i dcat=79 [gefunden am 2014-06-11]

## Beschreibung

### TECHNISCHES GEBIET

Die vorliegende Erfindung betrifft eine Vorrichtung zur Messung der Netzimpedanz eines elektrischen Versorgungsnetzes, und insbesondere eine Vorrichtung zur Messung der Netzimpedanz eines elektrischen Versorgungsnetzes, bei dem ein Null- bzw. Sternpunkt-Leiter nicht zugänglich ist, sowie ein zugehöriges Verfahren zur Messung der Netzimpedanz eines elektrischen Versorgungsnetzes.

### HINTERGRUND DER ERFINDUNG

Erneuerbare Energiequellen speisen ihre erzeugte Energie über leistungselektronische Umrichter in öffentliche Energieversorgungsnetze ein und beeinflussen durch ihre Netzrückwirkungen die Spannungsqualität des Netzes u.U. erheblich. Um das Potential eines Netzverknüpfungspunktes möglichst ökonomisch auszunutzen, ist die maximale Leistungseinspeisung in diesem Punkt gefordert, bei der dennoch alle Netzqualitätskriterien eingehalten werden. Aus der Kenntnis der frequenzabhängigen Netzimpedanz können genaue Aussagen über die Auslastung des Anschlusses gemacht werden. Durch die staatliche Förderung für erneuerbare Energien in Form des EEG-Gesetzes wächst die durchschnittliche Speiseleistung pro Anschlusspunkt rasant, so dass ein Übergang der Netzintegration von der Niederspannungsebene weg und hin zur Mittel- und Hochspannungsebene unerlässlich ist.

Eine Netzimpedanzmessung ist beispielsweise bekannt aus "Grid Impedance Determination - Relevancy for Grid Integration of Renewable Energy Systems", publiziert in IECON Juni 2009, sowie aus "Non-Sinusoidal Power Caused by Grid Impedance Measurement at Unbalanced Grid Voltage", publiziert in ISCNCC-Polen 2009.

Eine Umsetzung eines Messsystems auf der Mittel- und Hochspannungsebene stellt allerdings eine große Herausforderung an die eingesetzten Leistungskomponenten sowie die Mess- und Auswerteelektronik dar. Das Mittelspannungsnetz in Deutschland ist als dreiphasiges Drehstromsystem ausgeführt, welches meist keinen vierten Leiter als gemeinsamen Bezugsleiter für die stromführenden Phasen enthält. Durch den fehlenden Bezugsleiter ist das aufstellbare Gleichungssystem für die Berechnung der Phasenimpedanz unterbesetzt und ist somit ohne Weiteres nicht lösbar.

(Hauke Langowski et al., "Grid impedance determination - Relevancy for grid integration of renewable energy systems", IECON 2009, 516-521, ISBN: 978-1-4244-4648-3) offenbart ein Messprinzip zur Bestimmung der Netzimpedanz in einem Dreileitersystem auf der Mittel- und Hochspannungsebene. Dabei wird die Netzanregung durch eine Stern-Verschaltung von ohmschen Lastwiderständen dargestellt, welche durch drei ideale Schalter mit den Phasen des Netzes asynchron getaktet werden können.

Die EP 1 916 530 A1 offenbart eine Vorrichtung zur Messung der Impedanz eines elektrischen Versorgungsnetzes auf der Mittelspannungsebene.

Die US 2003/164 695 A1 offenbart ein Verfahren zum Einspeisen sinusförmiger Ströme im niederfrequenten Bereich, um die Netzimpedanz bei der energietechnischen Frequenz zu bestimmen.

Die DE 10 2004 059 100 A1 offenbart ein Verfahren zum Detektieren eines Inselnetzes durch Frequenzverschiebung der eingespeisten Grundschwingungskomponente eines Wechselrichters.

Die US 2008/036 472 A1 beschreibt ein Verfahren zum Erzeugen der Stromschwingungspakete durch Schalten von Widerständen, um die Netzimpedanz zu bestimmen.

### ZUSAMMENFASSUNG DER ERFINDUNG

Vor diesem Hintergrund kann es als eine Aufgabe der vorliegenden Erfindung betrachtet werden, eine Vorrichtung und ein Verfahren bereitzustellen zum Bestimmen der Netzimpedanz auf der Mittel- bzw. Hochspannungsebene, insbesondere bei fehlendem Bezugsleiter für die stromführenden Phasen.

Die Aufgabe der vorliegenden Erfindung wird gelöst durch den Gegenstand der unabhängigen Ansprüche, wobei vorteilhafte Ausgestaltungen in den abhängigen Ansprüchen wiedergegeben sind.

Gemäß der Erfindung wird eine Vorrichtung zur Messung der Netzimpedanz eines elektrischen Versorgungsnetzes in Form eines mehrphasigen Netzes bereitgestellt mit einer Anregungssignalerzeugungsvorrichtung, einer Last, einer Antwortsignalmessvorrichtung, einer Phasenumschaltvorrichtung, und einer Auswertevorrichtung, wobei die Anregungssignalerzeugungsvorrichtung ausgestaltet ist, um ein Anregungssignal auf ein verkettetes Phasenpaar eines mehrphasigen Netzes auszugeben, wobei die Antwortsignalmessvorrichtung ausgestaltet ist, um ein durch das Anregungssignal hervorgerufenes Antwortsignal zu messen, wobei die Phasenumschaltvorrichtung ausgestaltet ist, um nach Messung eines Anregungssignals von einem verketteten Phasenpaar auf ein anderes verkettetes Phasenpaar zu schalten, und wobei die Auswertevorrichtung ausgestaltet zum Ermitteln der Netzimpedanz der unverketteten Phasen eines mehrphasigen Netzes auf der Grundlage der Antwortsignale und der Anregungssignale der entsprechend verketteten Phasenpaare.

Auf diese Weise kann in einem Mittel- bzw. Hochspannungsnetz ohne vorhandenen Bezugsleiter oder in einem Mittel- bzw. Hochspannungsnetz ohne zugänglichen Bezugsleiter über die Messung der verketteten Phasenspannung die Netzimpedanz des Gesamtnetzes bestimmt werden, insbesondere im Fall eines unsymmetrischen Netzes. Auf diese Weise kann eine Vorrichtung und ein Verfahren zur Messung der Netzimpedanz bereitgestellt werden, mit der Möglichkeit eines unbeschränkten Einsatzes im Mittel- und Hochspannungsnetz, so dass die Netzimpedanz frequenzabhängig bestimmt werden kann. Insbesondere kann ein kompaktes Messsystem bereitgestellt werden mit einer intelligenten Dimensionierung der Anregelast mit unterschiedlichen Schaltungsvarianten mit einer geeigneten Ansteuerung zur Umsetzung eines asynchronen Schaltens. Die Anregungssignalerzeugungsvorrichtung kann beispielsweise einen oder mehrere IGBT Schalter aufweisen mit entsprechender Beschaltung.

Die Phasenumschaltvorrichtung umfasst eine erste ansteuerbare Halbleiterelementanordnung.

Auf diese Weise kann durch den Einsatz von Leistungselektronikschaltern eine flexible Ansteuerung vorgenommen werden. Insbesondere bei Verwendung von IGBT Halbleiterelementen können diese bis in den Kilohertz-Bereich getaktet werden und steile Impulse erzeugen, was für eine Anregung des Netzes von Bedeutung ist.

Die Phasenumschaltvorrichtung kann beispielsweise eine B6-Thyristorbrücke aufweisen, wobei das anzuregende verkettete Phasenpaar auf jeweiligen Knoten der B6-Thyristorbrücke anliegt, und wobei die Anregungssignalerzeugungsvorrichtung eine zweite ansteuerbare Halbleiterelementanordnung aufweist.

Auf diese Weise kann durch die B6-Thyristorbrücke ein Gleichrichten des Stroms und andererseits ein asynchrones Schalten realisiert werden.

Die Vorrichtung kann beispielsweise alternativ zu der B6-Thyristorbrücke eine B6-Diodenbrücke aufweisen, wobei die Phasenumschaltvorrichtung drei TRIACs in Form von jeweils zwei antiparallel geschalteten Thyristoren aufweist, wobei die Anregungssignalerzeugungsvorrichtung eine zweite ansteuerbare Halbleiterelementanordnung aufweist, wobei die anzuregenden verketteten Phasenpaare über die Halbleiterelementanordnung auf jeweilige Knoten der B6-Diodenbrücke geführt werden.

Auf diese Weise kann über die TRIACs ein asynchrones Schalten realisiert werden, während über die B6-Diodenbrücke eine Gleichrichtung erfolgen kann.

Gemäß der Erfindung weist die erste ansteuerbare Halbleiterelementanordnung der Phasenumschaltvorrichtung eine Brückenschaltung aus vier TRIACs in Form von jeweils zwei antiparallel geschalteten Thyristoren auf, wobei ein erster TRIAC mit einem ersten Brückenanschlusspunkt verbunden ist, ein zweiter TRIAC mit dem ersten Brückenanschlusspunkt verbunden ist, ein dritter TRIAC mit einem zweiten Brückenanschlusspunkt verbunden ist und ein vierter TRIAC mit einem zweiten Brückenanschlusspunkt verbunden ist, wobei die Anregungssignalerzeugungsvorrichtung aus zwei gegenläufig seriell angeordneten, ansteuerbaren zweiten Halbleiterelementanordnungen besteht, wobei die Anregungssignalerzeugungsvorrichtung zwischen dem ersten Brückenanschlusspunkt und dem zweiten Brückenanschlusspunkt angeordnet ist.

Auf diese Weise können die TRIACs so angesteuert werden, dass paarweise immer zwei TRIACs aktiv und zwei inaktiv sind. Damit wird das Schalten immer zwischen zwei Phasen ermöglicht, so dass eine Spannungsmessung immer jeweils zwischen zwei Phasen erfolgt.

Der vierpolige Ausgang der aus den vier TRIACs gebildeten Brückenschaltung ist mit dem elektrischen Versorgungsnetz verbindbar, indem zwei Ausgangsknotenpunkte der Brückenschaltung mit jeweils einem Eingangspunkt des elektrischen Versorgungsnetzes verbindbar sind, während die beiden anderen Ausgangsknotenpunkte der Brückenschaltung zu einem gemeinsamen Ausgangsknotenpunkt zusammengelegt sind, der mit einem dritten Eingangspunkt des elektrischen Versorgungsnetzes verbindbar ist.

Gemäß einer weiteren Ausführungsform der Erfindung weisen die ersten bzw. zweiten Halbleiterelementanordnungen eine Reihenschaltung von jeweils mindestens zwei Halbleiterelementen auf.

Auf diese Weise kann die bei Ein- und Ausschaltvorgängen entstehende Spannung gleichmäßig über alle Bauteile verteilt werden, ohne die entsprechenden Sperrspannungsgrenzen der jeweiligen Halbleiterelemente zu überschreiten.

Gemäß einer weiteren beispielhaften Ausführungsform ist die Last eine im Wesentlichen rein ohmsche Last.

Gemäß einer weiteren Ausführungsform der Erfindung ist die Last ein Spulensystem.

Auf diese Weise kann die Vorrichtung auch zur Ansteuerung eines Systems zur Erzeugung hoher Magnetfelder verwendet werden, insbesondere für Magnetresonanzgeräte in der Medizintechnik oder zur Erzeugung von Plasmen in Fusionskraftwerken. Zusätzlich kann man mit dieser Schaltung Impulslasten versorgen, die jeweils immer mit positiven Halbschwingungen versorgt werden sollen. Dazu kann die Last als Spulenlast ausgelegt werden. Ein eventuell vorhandener Lastwiderstand kann weggelassen werden und an die dann offenen Klemmen kann eine Spulenlast angeschlossen werden. Typische Anwendungsfälle für die mit Spulenlasten vorgeschlagenen Schaltungsvarianten bzw. mit zu versorgenden gepulsten Lasten sind beispielsweise Spulensysteme für Magnetspulen mit gepulster, jedoch gleich ausgerichteter Magnetfeldausrichtung, die ein starkes Magnetfeld von mehreren Tesla mit immer gleicher Magnetfeldrichtung erzeugen sollen, z B. für Magnetresonanzgeräte in der Medizintechnik, oder Spulensysteme mit gepulster, jedoch gleich ausgerichteter Magnetfeldausrichtung zur Fixierung eines Plasmas in Fusionskraftwerken.

Gemäß einer beispielhaften Ausführungsform der Erfindung ist das Spulensystem ein Spulensystem für Magnetspulen mit gepulster und gleich ausgerichteter Magnetfeldausrichtung.

Auf diese Weise kann eine Ansteuerung bzw. Anregung insbesondere eines Spulensystems für die Erzeugung eines Plasmas in Fusionskraftwerken bereitgestellt werden, oder für die Ansteuerung eines Beschleunigungssystems in einem Teilchenbeschleuniger.

Gemäß der Erfindung wird ein Verfahren zur Messung der Netzimpedanz eines elektrischen Versorgungsnetzes in Form eines mehrphasigen Netzes bereitgestellt, umfassend ein Erzeugen eines Anregungssignals zur Ausgabe auf ein verkettetes Phasenpaar eines mehrphasigen Netzes über eine Last, ein Messen eines durch das Anregungssignal hervorgerufenen Antwortsignals, ein Umschalten von einem verketteten Phasenpaar zu einem anderen verketteten Phasenpaar, ein Wiederholen der Schritte zum Erzeugen des Anregungssignals und zum Messen des Antwortsignals für jedes verkettete Phasenpaar, und ein Ermitteln der Netzimpedanz der unverketteten Phasen auf der Grundlage der Antwortsignale und der Anregungssignale der entsprechenden verketteten Phasenpaare.

Auf diese Weise wird ein Verfahren bereitgestellt, das mit der erfindungsgemäßen Vorrichtung zur Messung der Netzimpedanz betrieben werden kann. Insbesondere kann mit diesem Verfahren eine Netzimpedanz eines Mittel- bzw. Hochspannungsnetzes ermittelt werden, bei dem kein Bezugsleiter verfügbar ist oder kein Bezugsleiter besteht.

Gemäß einer Ausführungsform der Erfindung ist das elektrische Impulssignal ein zufällig pulsweitenmoduliertes Signal.

Auf diese Weise kann ein Ein- und Ausschalten der Halbleiterelemente, insbesondere der IGBT mit stochastisch variierenden Zeitabständen erfolgen, innerhalb eines begrenzten Intervalls. Dabei können beispielsweise viele unterschiedliche Frequenzen angeregt werden, die sich mehrheitlich in einem definierten Spektralbereich überlagern können. Die Größe und Lage des angeregten Frequenzbandes können über die Grenzen des Intervalls beeinflusst werden.

Gemäß einer beispielhaften Ausführungsform der Erfindung erfolgt das Ermitteln der Netzimpedanz auf der Grundlage einer Auswertung eines linearen Gleichungssystems.

Auf diese Weise kann eine leichte rechnergestützte Auswertung erfolgen, insbesondere da lineare Gleichungssysteme über einfache Matrixberechnungen gelöst werden können.

Gemäß einer weiteren Ausführungsform der Erfindung ist auch bei dem Verfahren die Last eine im Wesentlichen rein ohmsche Last.

Gemäß einer weiteren Ausführungsform der Erfindung ist auch bei dem Verfahren die Last ein Spulensystem.

Gemäß einer weiteren Ausführungsform der Erfindung ist das Spulensystem ein Spulensystem für Magnetspulen mit gepulster und gleich ausgerichteter Magnetfeldausrichtung.

Gemäß einer weiteren beispielhaften Ausführungsform der Erfindung wird ein Computerprogramm angegeben, welches, wenn es durch einen Prozessor ausgeführt wird, ausgelegt ist, um das erfindungsgemäße Verfahren durchzuführen. Darüber hinaus wird gemäß einer weiteren beispielhaften Ausführungsform der Erfindung ein computerlesbares Medium angegeben, auf dem das erfindungsgemäße Computerprogramm gespeichert ist.

Es sollte bemerkt werden, dass sich die vorangegangenen bzw. im Folgenden beschriebenen Ausführungsformen der Erfindung gleichermaßen auf die Vorrichtung als auch das Verfahren, das Computerprogramm und das computerlesbare Speichermedium beziehen.

Die einzelnen Merkmale können, sofern nicht explizit anders angegeben, selbstverständlich auch untereinander kombiniert werden, wodurch sich zum Teil auch vorteilhafte Wirkungen einstellen können, die über die Summe der Einzelwirkungen hinausgehen.

Diese und andere Aspekte der vorliegenden Erfindung werden durch die Bezugnahme auf die hiernach beschriebenen beispielhaften Ausführungsformen erläutert und verdeutlicht.

### KURZE BESCHREIBUNG DER FIGUREN

Beispielhafte Ausführungsformen werden im Folgenden mit Bezugnahme auf die folgenden Zeichnungen beschrieben.
- Figur 1: zeigt ein prinzipielles Schaltbild einer Vorrichtung zur Messung der Netzimpedanz mit einer B6-Thyristorbrückenschaltung.
- Figur 2: zeigt eine Vorrichtung zur Messung der Netzimpedanz mit einer B6-Thyristorbrückenschaltung, bei der eine Mehrzahl von Halbleiterelementen in Reihe geschaltet sind.
- Figur 3: zeigt eine Vorrichtung zur Messung der Netzimpedanz mit einer TRIAC-Schaltung und einer B6-Diodenbrückenschaltung.
- Figur 4: zeigt eine Vorrichtung zur Messung der Netzimpedanz mit einer TRIAC-Schaltung und einer B6-Diodenbrückenschaltung, bei der eine Mehrzahl von Halbleiterelementen in Reihe geschaltet ist.
- Figur 5: zeigt eine Vorrichtung zur Messung der Netzimpedanz gemäß einer beispielhaften Ausführungsform der Erfindung, bei der vier TRIACs in einer Brücke geschaltet sind.
- Figur 6: zeigt eine Vorrichtung zur Messung der Netzimpedanz gemäß einer beispielhaften Ausführungsform der Erfindung, bei der die TRIACs in einer Brücke aus einer Reihenschaltung von Halbleiterelementen bestehen.
- Figur 7: zeigt einen schematischen Ablauf eines Verfahrens zur Messung der Netzimpedanz gemäß einer beispielhaften Ausführungsform der Erfindung.
- Figur 8: zeigt einen Taktsignalablauf, einen Stromverlauf und einen Spannungsverlauf bei einer Schaltung gemäß Figur 1.

### DETAILIERTE DARSTELLUNG BEISPIELHAFTER

### AUSFÜHRUNGSFORMEN

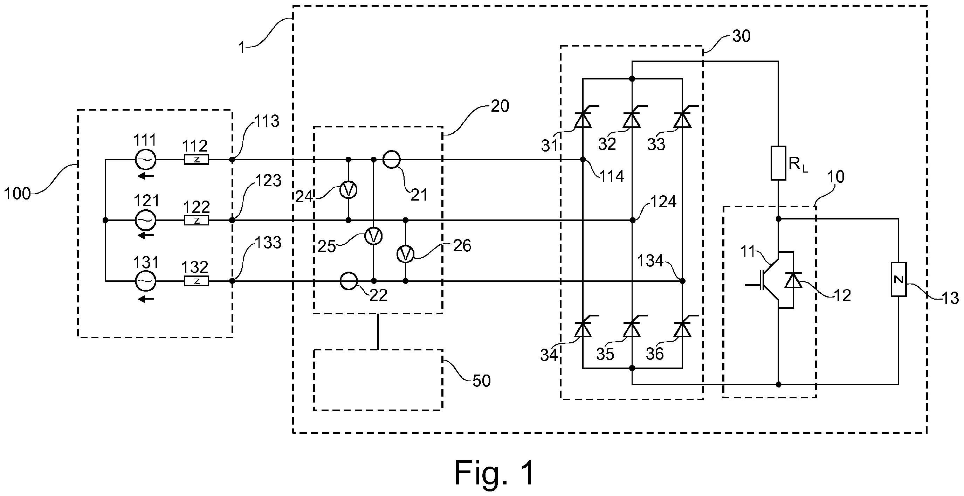

Die im Folgenden dargestellten Schaltungen der Figuren 1 bis 6 sind geeignet, um das Prinzip des asynchronen Schaltens umzusetzen, in dem abwechselnd immer zwischen zwei Phasen geschaltet wird. Auf diese Weise kann eine zusätzliche unabhängige Gleichung für ein lineares Gleichungssystem aufgestellt werden, wodurch die Netzimpedanzen der drei Phasen eindeutig bestimmt werden können. Dieses Prinzip lässt sich sowohl auf der Mittelspannungsebene als auch auf der Hochspannungsebene unter Verwendung der angegebenen Schaltungen verwenden, entsprechend einer Spannungsdimensionierung der Schalterelemente. Durch die angegebenen Schaltungen bzw. Schaltungsvarianten können die benötigten leistungselektronischen Bauelemente und Leistungswiderstände für die Anregung des Netzes erheblich reduziert werden. Durch einen Einsatz von leistungselektronischen Schaltern kann die Last flexibel angesteuert werden. Zum Einen können mit aktiv ein- und ausschaltbaren IGBT-Schaltern steile Stromimpulse erzeugt werden, die eine Auswertung der Netzimpedanz im hohen Frequenzbereich möglich machen. Zum anderen kann mit den angesetzten TRIACs (antiparallel geschalteten Thyristoren) die Auswahl von jeweils zwei Phasen für eine Messung erfolgen. Da es sich bei einem Mittelspannungs- bzw. Hochspannungsnetz um ein Dreileiternetz handelt, und ein Bezugsleiter oft entweder nicht vorhanden oder nicht zugänglich ist, kann bei diesen Netzen oft nur eine verkettete Spannung zwischen zwei Phasen gemessen werden, jedoch nicht die Spannung zwischen einer Phase und dem Bezugsleiter. Die Bestimmung der Netzimpedanz aus der verketteten Phasenspannung mit der Netzanregung mittels einer dreiphasigen Last ist nicht direkt möglich. Bei einer Annahme eines virtuellen Sternpunktes können jedoch nur Rückschlüsse auf eine virtuelle Netzimpedanz gezogen werden, die jedoch lediglich in einem vollständig symmetrischen Netz identisch mit den realen Netzimpedanzen sind. Im Fall eines unsymmetrischen Netzes ist dies jedoch nicht der Fall.

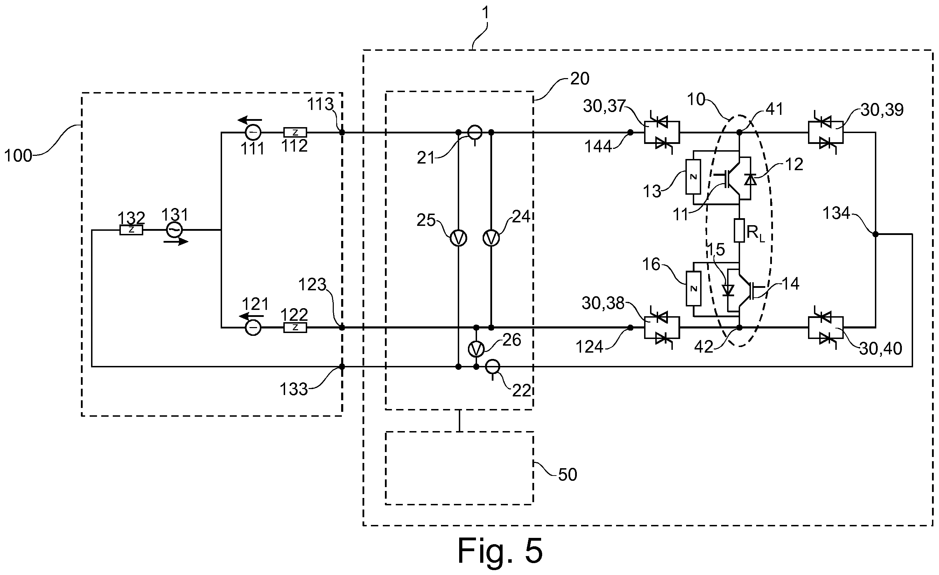

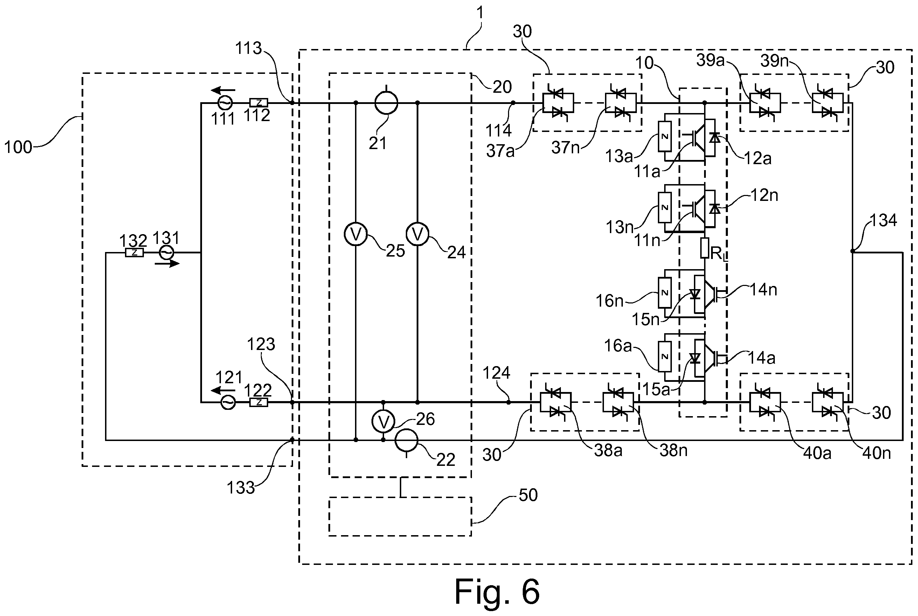

Um die Netzimpedanz zu bestimmen, kann der das Netz anregende Widerstand an den Netzanschluss angeschlossen werden. Für die impulsförmige Anregung können Hochleistungs-IGBT-Schalter zur Taktung verwendet werden, die standardmäßig eine antiparallele Freilaufdiode enthalten zum Schutz des Leistungshalbleiterschalters beim Schalten induktiver Lasten. Zusammen mit der integrierten Freilaufdiode kann das IGBT-Modul in der positiven Halbwelle den Strom impulsförmig takten, während in der negativen Halbwelle der Strom ohne Taktung durch die Freilaufdiode abfließen kann. Damit auch in der negativen Halbwelle eine Anregung erfolgen kann, kann die Eingangsspannung entweder über eine B6-Gleichrichterbrücke gemäß der Figuren 1 bis 4 gleichgerichtet werden, hier über eine Diodenbrücke bzw. eine Thyristorbrücke, oder der IGBT-Schalter kann als bidirektionaler Schalter verschaltet sein gemäß der Figuren 5 und 6. Neben der Möglichkeit, mit IGBT-Schaltern impulsförmige Anregungen des Netzes zu erreichen, können die eingesetzten Thyristorschaltungen die Möglichkeiten des erfindungsgemäßen Verfahrens zur Messung der Netzimpedanz eines elektrischen Versorgungsnetzes mittels asynchronen Schaltens von jeweils zwei Phasen realisieren. Zusätzlich kann jederzeit bei Überschreitung einer zulässigen Betriebstemperatur der Leistungskreis bei dem nächsten Strom Nulldurchgang passiv vom Netz getrennt werden und eine Abkühlphase der belasteten Widerstände folgen.

Alternativ kann mit den angegebenen Schaltungen eine Impulslast versorgt werden, die jeweils immer mit positiven Halbschwingungen versorgt werden soll. Zu diesem Zweck kann der Lastwiderstand weggelassen werden und an die dann offenen Klemmen eine andere Last angeschlossen werden. Es sei verstanden, dass die dann angeschlossene Last nicht zwingend eine ohmsche Last sein muss, sondern auch eine induktive Last sein kann. Typische Anwendungsfälle für die mit den vorgeschlagenen Schaltungsvarianten zu versorgenden gepulsten Lasten sind beispielsweise Spulensysteme für Magnetspulen mit gepulster, jedoch gleich ausgerichteter Magnetfeldausrichtung, die ein starkes Magnetfeld von mehreren Tesla mit immer gleicher Magnetfeldrichtung erzeugen sollen, zum Beispiel für Magnetresonanzgeräte in der Medizintechnik. Ferner können die zu versorgenden gepulsten Lasten ein Spulensystem mit gepulster, jedoch gleich ausgerichteter Magnetfeldausrichtung zur Fixierung eines Plasmas in Fusionskraftwerken sein. Ein Spulensystem kann auch ein Spulensystem mit gepulster, jedoch gleich ausgerichteter Magnetfeldausrichtung zur Beschleunigung von Teilchen in Teilchenbeschleunigern sein, oder ein Spulensystem mit gepulster, jedoch gleich ausgerichteter Magnetfeldausrichtung zur hohen linearen oder radialen Beschleunigung von magnetischen oder metallischen Körpern für die Werkstoffprüfung oder als Schusseinrichtungen.

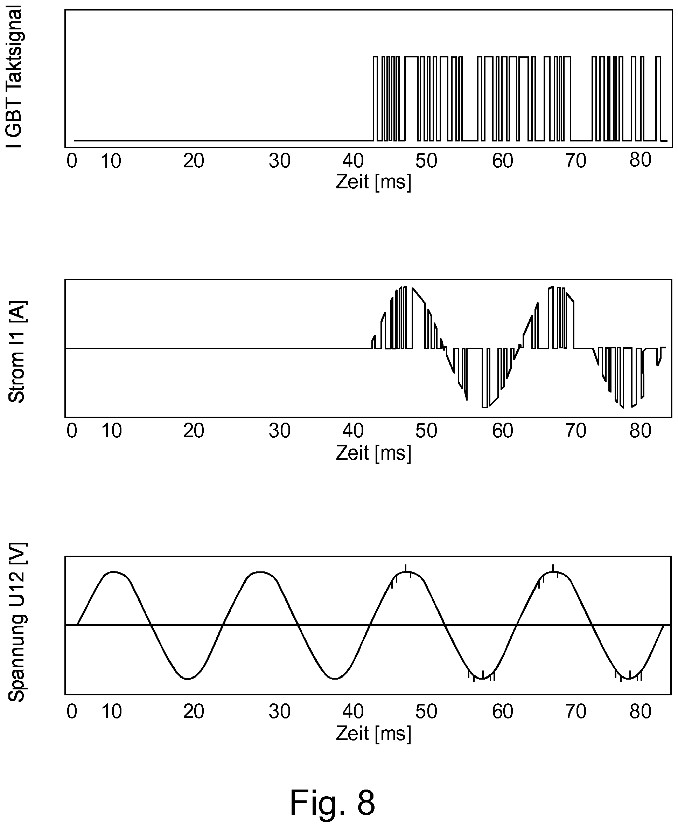

Figur 1 zeigt eine Schaltungsvariante, die aus einer B6-Thyristorbrücke als Phasenumschaltvorrichtung 30 besteht und einem unidirektionalen IGBT-Schalter mit einem Snubber-Kreis, wobei der IGBT 10 mit dem eigentlichen Halbleiterelement 11 und einer antiparallelen Freilaufdiode 12 versehen ist. Der Snubber-Kreis kann dabei die beim Ausschalten auftretenden überschüssigen induktiven Blindenergien aufnehmen. Er kann beispielsweise aus einer Reihenschaltung von einer Kapazität und einem Widerstand bestehen. Die Kapazität soll gegenüber der Wechselspannung hochohmig wirken und kann die Aufgabe der Spannungsaufteilung übernehmen. Der Widerstand jedoch kann relativ niederohmig sein, um die Kapazität möglichst schnell zu entladen. Die B6-Thyristorbrückenschaltung 30 besteht dabei aus insgesamt sechs Thyristoren 31 - 36, wobei parallel zu der Brücke die Anregungssignalerzeugungsvorrichtung 10, hier in Form eines IGBTs in Reihe geschaltet mit einer Last R_{L} geschaltet ist. Die Vorrichtung zur Messung der Netzimpedanz 1 weist ferner eine Antwortsignalmessvorrichtung 20 auf, die aus einer Mehrzahl von Strommessern 21, 22 bzw. Spannungsmessern 24, 25, 26 bestehen kann. Die mit den Strom- bzw. Spannungsmessern ermittelten Werte werden dann an eine Auswertevorrichtung 50 weitergegeben, die ebenfalls Bestandteil der Vorrichtung 1 zur Messung der Netzimpedanz eines elektrischen Versorgungsnetzes sein kann. Diese Vorrichtung 1 zur Messung der Netzimpedanz kann dann an ein zu messendes Versorgungsnetz 100 angeschlossen werden, das beispielsweise einen nicht zugänglichen Sternpunkt aufweist oder bei einer Dreiecksschaltung keinen Sternpunkt aufweist. Das Netz kann ersatzweise angegeben werden durch die in den drei Zweigen vorliegenden Spannungsquellen 111, 121, 131 sowie dazu in Reihe geschalteten Impedanzen 112, 122, 132. Über entsprechende Anschlussklemmen 113, 123, 133 kann die Vorrichtung 1 zur Messung der Netzimpedanz an das zu messende Versorgungsnetz 100 angeschlossen werden. Dabei kann beispielsweise über eine definierte Anzahl von 50 Hz Schwingungen die Leerlaufspannung U_{Null} bei geöffnetem IGBT-Schalter gemessen werden. Anschließend kann über die gleiche Anzahl von Schwingungen der IGBT-Schalter mit einer Random Pulse Width Modulation (RPWM, zufällig pulsweitenmoduliertes Signal) angesteuert werden und die Strom- bzw. Spannungswerte simultan gemessen werden. Das Ein- bzw. Ausschalten des IGBT-Schalters kann dabei einen pulsförmigen Stromverlauf in den jeweilig verbundenen Phasen verursachen, welcher abhängig von der Netzimpedanz der Phase zu Spannungseinbrüchen bzw. zu Spannungsspitzen führt. Ein derart zeitlicher Verlauf des IGBT-Taktsignals, eines Stroms bzw. einer Spannung wird in Figur 8 gezeigt.

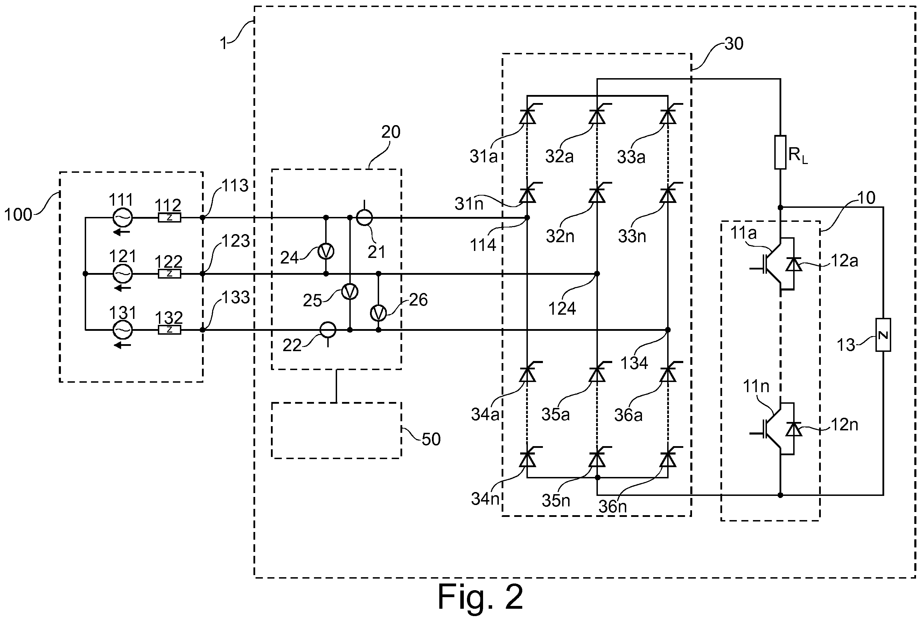

In Figur 2 wird eine der Figur 1 ähnliche Schaltung einer Vorrichtung zur Messung von Netzimpedanzen 1 gezeigt, bei der jedoch die Halbleiterelemente der Phasenumschaltvorrichtung 30 sowie die Halbleiterelemente der Anregungssignalerzeugungsvorrichtung 10 aus einer Reihenschaltung von entsprechenden Halbleiterschaltern besteht, die jeweils mit dem Index a bis n bezeichnet sind. Auf diese Weise kann die Schaltungsvariante so modifiziert werden, dass sie für eine entsprechend höhere Spannungsebene angewendet werden kann. Die Schaltung ist dann so ausgelegt, dass die bei Ein- und Ausschaltvorgängen entstehende Überspannung gleichmäßig über alle Bauelemente verteilt wird. Dies kann durch hier nicht gezeigte parallele hochohmige Widerstände und/oder niederkapazitive Kondensatoren erreicht werden. Auf diese Weise werden die Sperrspannungsgrenzen der jeweiligen Halbleiterelemente bzw. Module nicht überschritten. Im Übrigen korrespondieren die verwendeten Bezugszeichen der Figur 2 mit denen der Figur 1.

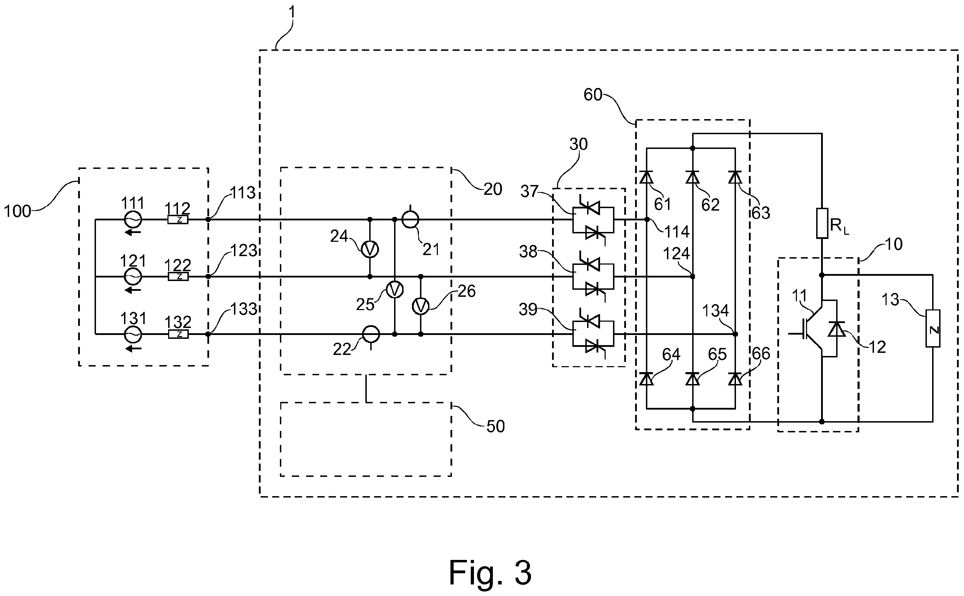

Figur 3 zeigt eine alternative Ausgestaltung einer Vorrichtung 1 zur Messung der Netzimpedanz eines elektrischen Versorgungsnetzes 100, bei der im Vergleich zu Figur 1 anstelle der B6-Thyristorbrückenschaltung eine B6-Diodenbrückenschaltung 60 verwendet wird, die mit entsprechenden Dioden 61 bis 66 versehen ist. An den entsprechenden Abgriffspunkten 114, 124, 134 wird eine Phasenumschaltvorrichtung 30 vorgesehen, die hier mit TRIACs 37, 38, 39 ausgestaltet ist. Die Phasenumschaltvorrichtung 30 mit den TRIACs 37, 38, 39 übernimmt hier die Aufgabe des asynchronen Schaltens. Für diese Schaltung, ebenso wie für die Schaltung der Figur 1 und die Schaltung der Figur 2 kann ein unidirektionaler IGBT-Schalter für die Taktung der Last verwendet werden. Der Snubber-Kreis ist analog dem, der mit Bezugnahme auf Figur 1 beschrieben wurde. Dieser kann die überschüssige induktive Energie beim Ausschalten aufnehmen.

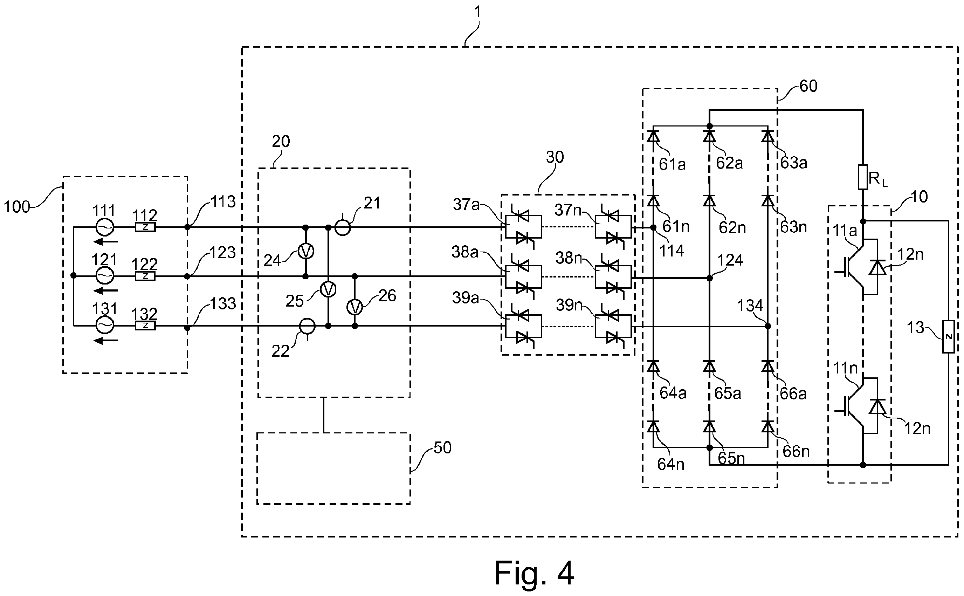

Figur 4 zeigt eine Erweiterung der mit Bezugnahme auf Figur 3 beschriebenen Vorrichtung 1 zur Messung der Netzimpedanz, bei der die Halbleiterelemente in der Diodenbrückenschaltung 60 sowie der Phasenumschaltvorrichtung 30 durch eine Reihenschaltung von Halbleiterelementen ersetzt wurde. Insbesondere ist in der Phasenumschaltvorrichtung 30 eine Reihenschaltung von TRIACs 37, 38, 39 vorgesehen, deren jeweilige Reihenschaltung indiziert ist mit den Indizes a bis n. Analog können die in der B6-Diodenbrückenschaltung 60 verwendeten Dioden 61 bis 66 jeweils durch eine Reihenschaltung von Dioden ersetzt werden, die entsprechend indiziert sind mit a bis n. Analog kann auch der Anregungssignalerzeugungshalbleiter 10 durch eine entsprechende Reihenschaltung ersetzt werden. Es sei angemerkt, dass die Bezugnahme auf Figur 2 und Figur 4, später auch Figur 6 gezeigte Kombination von Reihenschaltungen von Halbleiterelementen variabel erfolgen kann, je nachdem, welche Bauelemente verfügbar und sinnvoll eingesetzt werden können. So können beispielsweise in einer der Vorrichtungen 10, 30, 60 eine Reihenschaltung von Halbleiterelementen eingesetzt werden, während in einer anderen Vorrichtung der Vorrichtungen 10, 30, 60 nur einzelne Halbleiterelemente eingesetzt werden können.

Figur 5 zeigt eine weitere Schaltungsvariante der Vorrichtung 1 zur Messung der Netzimpedanz eines elektrischen Versorgungsnetzes 100, wobei auch diese Schaltung zur Anregung der Netzimpedanz verwendet werden kann. In der hier gezeigten Ausführungsform ist die Vorrichtung zur Messung der Netzimpedanz 1 mit einer Phasenumschaltvorrichtung 30 versehen, die aus einer Brückenschaltung von vier TRIACs 37, 38, 39, 40 besteht. Der vierpolige Ausgang der Brücke wird dabei auf die entsprechenden Eingangsknotenpunkte 113, 123, 133 des zu messenden Versorgungsnetzes 100 gelegt, wobei zwei der Ausgangsknotenpunkte 124, 144 jeweils mit einem Eingangspunkt des Netzes 113bzw. 123 verbunden wird, während die beiden anderen Ausgangspunkte der Brücke der Phasenumschaltvorrichtung 30 zusammengelegt werden als gemeinsamer Ausgangspunkt 134, der dann auf den Eingangspunkt 133 des zu messenden Versorgungsnetzes 100 gelegt wird. Im Brückenzweig zwischen den Knotenpunkt 41 und 42 befindet sich dann ein bidirektionaler Halbleiterschalter, beispielsweise ein bidirektionaler IGBT-Schalter, der hier sowohl in der positiven als auch in der negativen Halbwelle den Strom leiten kann. Durch seine Eigenschaft selbstführend zu sein, kann der Schalter steile Impulse erzeugen und somit hohe Frequenzanteile der Netzimpedanz anregen. Analog zu den Figuren 1 bis 4 ist parallel zu dem IGBT-Schalter jeweils wieder ein Snubber-Kreis 13, 16 vorgesehen, der beim Ausschalten auftretende überschüssige induktive Blindenergie aufnimmt. Die TRIACs 37, 38, 39, 40 können so angesteuert werden, dass paarweise immer zwei TRIACs aktiv und zwei TRIACs inaktiv sind. Damit wird das Schalten immer zwischen zwei Phasen am Eingang vor der Anregungssignalerzeugungsvorrichtung und der Antwortsignalmessvorrichtung 20 ermöglicht.

Figur 6 zeigt eine analog Figur 5 ausgestaltete Vorrichtung 1 zur Messung der Netzimpedanz, bei der wiederum die unterschiedlichen Halbleiterelemente als eine Reihenschaltung von Halbleiterelementen ausgeführt sein kann, die jeweils dann mit a bis n indiziert sind.

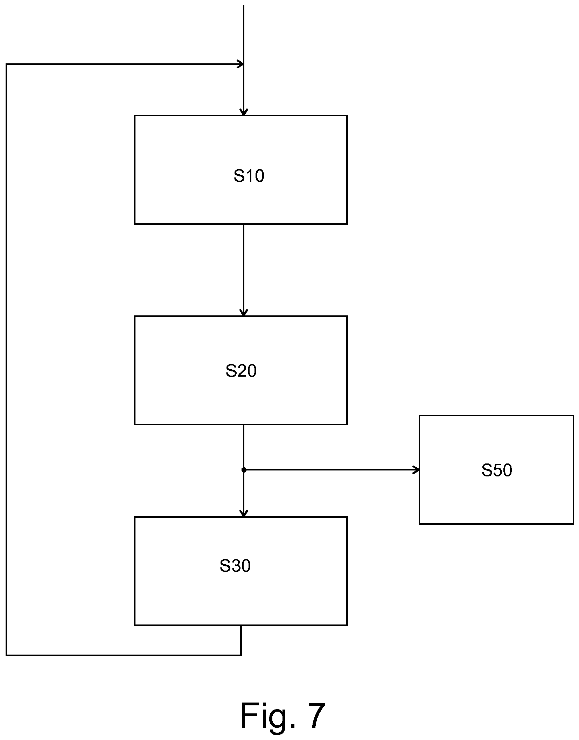

Figur 7 zeigt einen schematischen Ablauf eines Verfahrens zur Messung der Netzimpedanz, wobei in einem Schritt S10 ein Anregungssignal erzeugt wird zur Ausgabe auf ein verkettetes Phasenpaar eines mehrphasigen Netzes über eine Last. Im Schritt S20 wird dann eine Messung eines durch das Anregungssignal hervorgerufenen Antwortsignals durchgeführt, während anschließend im Schritt S30 ein Umschalten von einem verketteten Phasenpaar zu einem anderen verketteten Phasenpaar erfolgt. Diese Schritte werden entsprechend wiederholt, bis sämtliche zur Messung vorgesehenen Phasenpaarungen gemessen wurden. Die in den jeweiligen Durchläufen ermittelten Messergebnisse können dann in einem Schritt S50 verwendet werden, um die Netzimpedanz der unverketteten Phasen auf der Grundlage der Antwortsignale und der Anregungssignale der entsprechenden verketteten Phasenpaare zu ermitteln.

Figur 8 zeigt beispielhafte Verläufe von Ansteuerungspulsen für die Anregungssignalerzeugungsvorrichtung, die sich einstellenden Ströme und die auftretenden Spannungen.

Es sei verstanden, dass die Vorrichtung und das Verfahren zur Messung von Netzimpedanzen in den zuvor beschriebenen Ausführungsformen jeweils anhand eines dreiphasigen Netzes beschrieben wurden, das jedoch auch mehrphasige Netze mit einer derartigen Vorrichtung und einem derartigen Verfahren gemessen werden können zur Bestimmung der Netzimpedanzen.

Es sei angemerkt, dass der Begriff "umfassen" weitere Elemente oder Verfahrensschritte nicht ausschließt, ebenso wie die Begriffe "ein" und "eine" mehrere Elemente und Schritte nicht ausschließen. Die verwendeten Bezugszeichen dienen lediglich zur Erhöhung der Verständlichkeit und sollen keinesfalls als einschränkend betrachtet werden, wobei der Schutzbereich der Erfindung durch die Ansprüche wiedergegeben wird.

## Patentansprüche

1. Vorrichtung (1) zur Messung der Netzimpedanz eines elektrischen Versorgungsnetzes (100) in Form eines mehrphasigen Netzes, mit:
einer Anregungssignalerzeugungsvorrichtung (10),
einer Last (RL)
einer Antwortsignalmessvorrichtung (20),
einer Phasenumschaltvorrichtung (30),
einer Auswertevorrichtung (50);
wobei die Anregungssignalerzeugungsvorrichtung (10) ausgestaltet ist, um ein Anregungssignal über die Last (RL) auf ein verkettetes Phasenpaar (113, 123; 113, 133; 123, 133) des elektrischen Versorgungsnetzes (100) auszugeben,
wobei die Antwortsignalmessvorrichtung (20) ausgestaltet ist, um ein durch das Anregungssignal hervorgerufenes Antwortsignal zu messen,
wobei die Phasenumschaltvorrichtung (30) eine erste ansteuerbare Halbleiterelementanordnung umfasst und ausgestaltet ist, um nach Messung eines Antwortsignals von einem verketteten Phasenpaar (113, 123; 113, 133; 123, 133) auf ein anderes verkettetes Phasenpaar zu schalten,
wobei die Auswertevorrichtung (50) ausgestaltet ist zum Ermitteln der Netzimpedanz (112, 122, 132) der unverketteten Phasen (111, 121, 131) des elektrischen Versorgungsnetzes (100) auf der Grundlage der Antwortsignale und der Anregungssignale der entsprechenden verketteten Phasenpaare,
**dadurch gekennzeichnet, dass** die erste ansteuerbare Halbleiterelementanordnung der Phasenumschaltvorrichtung (30) eine Brückenschaltung aus vier TRIACs in Form von jeweils zwei antiparallel geschalteten Thyristoren (30, 37; 30, 38; 30, 39; 30, 40) aufweist,
wobei ein erster TRIAC (30, 37) mit einem ersten Brückenanschlusspunkt (41) verbunden ist,
wobei ein zweiter TRIAC (30, 39) mit dem ersten Brückenanschlusspunkt (41) verbunden ist,
wobei ein dritter TRIAC (30, 38) mit einem zweiten Brückenanschlusspunkt (42) verbunden ist,
wobei ein vierter TRIAC (30, 40) mit dem zweiten Brückenanschlusspunkt (42) verbunden ist,
wobei der vierpolige Ausgang der aus den vier TRIACs (37, 38, 39, 40) gebildeten Brückenschaltung mit dem elektrischen Versorgungsnetz (100) verbindbar ist, indem zwei Ausgangsknotenpunkte (124, 144) der Brückenschaltung mit jeweils einem Eingangspunkt (113, 123) des elektrischen Versorgungsnetzes (100) verbindbar sind, während die beiden anderen Ausgangsknotenpunkte der Brückenschaltung zu einem gemeinsamen Ausgangsknotenpunkt (134) zusammengelegt sind, der mit einem dritten Eingangspunkt (133) des elektrischen Versorgungsnetzes (100) verbindbar ist,
wobei die Anregungssignalerzeugungsvorrichtung (10) aus zwei gegenläufig seriell angeordneten ansteuerbaren zweiten Halbleiterelementanordnungen (11, 15) besteht,
wobei die Anregungssignalerzeugungsvorrichtung (10) zwischen dem ersten Brückenanschlusspunkt (41) und dem zweiten Brückenanschlusspunkt (42) angeordnet ist.

2. Vorrichtung nach Anspruch 1, wobei die Phasenumschaltvorrichtung (30) und die Last (RL) in Reihe geschaltet sind.

3. Vorrichtung nach einem der Ansprüche 1 bis 2, wobei die Last (RL) eine im Wesentlichen rein ohmsche Last ist.

4. Vorrichtung nach einem der Ansprüche 1 bis 2, wobei die Last (RL) ein Spulensystem ist.

5. Vorrichtung nach Anspruch 4, wobei das Spulensystem ein Spulensystem für Magnetspulen mit gepulster und gleich ausgerichteter Magnetfeldausrichtung ist.

6. Verfahren zur Messung der Netzimpedanz eines elektrischen Versorgungsnetzes (100) in Form eines mehrphasigen Netzes, umfassend:
Erzeugen eines Anregungssignals (S10) zur Ausgabe auf ein verkettetes Phasenpaar (113, 123; 113, 133; 123, 133) des elektrischen Versorgungsnetzes (100), über eine Last (RL)
Messen eines durch das Anregungssignal hervorgerufenen Antwortsignals (S20),
Umschalten (S30) von einem verketten Phasenpaar (113, 123; 113, 133; 123, 133) zu einem anderen verketteten Phasenpaar;
Wiederholen der Schritte zum Erzeugen des Anregungssignals und zum Messen des Antwortsignals für jedes verkette Phasenpaar (113, 123; 113, 133; 123, 133);
Ermitteln der Netzimpedanz (S50) der unverketteten Phasen (112, 122, 132) auf der Grundlage der Antwortsignale und der Anregungssignale der entsprechenden verketteten Phasenpaare;
wobei die Phasenumschaltvorrichtung (30) eine erste ansteuerbare Halbleiterelementanordnung umfasst und ausgestaltet ist, um nach Messung eines Antwortsignals von einem verketteten Phasenpaar (113, 123; 113, 133; 123, 133) auf ein anderes verkettetes Phasenpaar zu schalten,
wobei die Auswertevorrichtung (50) ausgestaltet ist zum Ermitteln der Netzimpedanz (112, 122, 132) der unverketteten Phasen (111, 121, 131) des elektrischen Versorgungsnetzes (100) auf der Grundlage der Antwortsignale und der Anregungssignale der entsprechenden verketteten Phasenpaare,
**dadurch gekennzeichnet, dass** die erste ansteuerbare Halbleiterelementanordnung der Phasenumschaltvorrichtung (30) eine Brückenschaltung aus vier TRIACs in Form von jeweils zwei antiparallel geschalteten Thyristoren (30, 37; 30, 38; 30, 39; 30, 40) aufweist,
wobei ein erster TRIAC (30, 37) mit einem ersten Brückenanschlusspunkt (41) verbunden ist,
wobei ein zweiter TRIAC (30, 39) mit dem ersten Brückenanschlusspunkt (41) verbunden ist,
wobei ein dritter TRIAC (30, 38) mit einem zweiten Brückenanschlusspunkt (42) verbunden ist,
wobei ein vierter TRIAC (30, 40) mit dem zweiten Brückenanschlusspunkt (42) verbunden ist,
wobei der vierpolige Ausgang der aus den vier TRIACs (37, 38, 39, 40) gebildeten Brückenschaltung mit dem elektrischen Versorgungsnetz (100) verbunden ist, indem zwei Ausgangsknotenpunkte (124, 144) der Brückenschaltung mit jeweils einem Eingangspunkt (113, 123) des elektrischen Versorgungsnetzes (100) verbunden sind, während die beiden anderen Ausgangsknotenpunkte der Brückenschaltung zu einem gemeinsamen Ausgangsknotenpunkt (134) zusammengelegt sind, der mit einem dritten Eingangspunkt (133) des elektrischen Versorgungsnetzes (100) verbunden ist,
wobei die Anregungssignalerzeugungsvorrichtung (10) aus zwei gegenläufig seriell angeordneten ansteuerbaren zweiten Halbleiterelementanordnungen (11, 15) besteht,
wobei die Anregungssignalerzeugungsvorrichtung (10) zwischen dem ersten Brückenanschlusspunkt (41) und dem zweiten Brückenanschlusspunkt (42) angeordnet ist.

7. Verfahren nach Anspruch 6, wobei das elektrische Impulssignal ein zufälliges Pulsweiten moduliertes Signal ist.

8. Verfahren nach einem der Ansprüche 6 und 7, wobei das Ermitteln der Netzimpedanz auf der Grundlage einer Auswertung eines linearen Gleichungssystems erfolgt.

9. Verfahren nach einem der Ansprüche 6 bis 8, wobei die Last (RL) eine im Wesentlichen rein ohmsche Last ist.

10. Verfahren nach einem der Ansprüche 6 bis 8, wobei die Last (RL) ein Spulensystem ist.

11. Verfahren nach Anspruch 10, wobei das Spulensystem ein Spulensystem für Magnetspulen mit gepulster und gleich ausgerichteter Magnetfeldausrichtung ist.

## Claims

1. Device (1) for measuring the network impedance of an electric supply network (100) in the form of a multi-phase network, having:
an excitation signal generating device (10),
a load (RL),
a response signal measuring device (20),
a phase switching device (30),
an evaluation device (50);
wherein the excitation signal generating device (10) is configured to output an excitation signal across the load (RL) onto an interlinked phase pair (113, 123; 113, 133; 123, 133) of the electrical supply network (100),
wherein the response signal measuring device (20) is configured to measure a response signal induced by the excitation signal,
wherein the phase switching device (30) comprises a first controllable semiconductor arrangement and is configured, after measurement of a response signal from one interlinked phase pair (113, 123; 113, 133; 123, 133) to switch to another interlinked phase pair, wherein the evaluation device (50) is configured to determine the network impedance (112, 122, 132) of the non-interlinked phases (111, 121, 131) of the electrical supply network (100) on the basis of the response signals and of the excitation signals of the corresponding interlinked phase pairs,
**characterized in that**
the first controllable semiconductor arrangement of the phase shifting device (30) has a bridge circuit consisting of four TRIACs, each in the form of two antiparallel connected thyristors (30, 37; 30, 38; 30, 39; 30, 40),
wherein a first TRIAC (30, 37) is connected to a first bridge connection point (41),
wherein a second TRIAC (30, 39) is connected to the first bridge connection point (41),
wherein a third TRIAC (30, 38) is connected to a second bridge connection point (42),
wherein a fourth TRIAC (30, 40) is connected to the second bridge connection point (42),
wherein the four-pole output of the bridge circuit formed by the four TRIACS (37, 38, 39, 40) can be connected to the electrical supply network (100) by two output nodes (124, 144) of the bridge circuit being connectable to one input node (113, 123) each of the electrical supply network (100), while the other two output nodes of the bridge circuit are combined to form a common output node (134), which is connectable to a third input point (133) of the electrical supply network (100),
wherein the excitation signal generating device (10) consists of two contrary serially arranged second semiconductor arrangements (11, 15),
wherein the excitation signal generating device (10) is arranged between the first bridge connection point (41) and the second bridge connection point (42).

2. Device according to Claim 1,
wherein the phase switching device (30) and the load (RL) are connected in series.

3. Device according to any one of the Claims 1 to 2,
wherein the load (RL) is a substantially pure resistive load.

4. Device according to any one of the Claims 1 to 2,
wherein the load (RL) is a coil system.

5. Device according to Claim 4, wherein the coil system is a coil system for magnetic coils with pulsed and identically oriented magnetic field orientation.

6. Method for measuring the network impedance of an electrical supply network (100) in the form of a multi-phase network, comprising:
generating an excitation signal (S10) for outputting onto an interlinked phase pair (113, 123; 113, 133; 123, 133) of the electrical supply network (100) through a load (RL)
measuring a response signal (S20) induced by the excitation signal,
switching (S30) from one interlinked phase pair (113, 123; 113, 133; 123, 133) to another interlinked phase pair;
repeating the steps for generating the excitation signal and for measuring the response signal for each interlinked phase pair (113, 123; 113, 133; 123, 133);
determining the network impedance (S50) of the non-interlinked phases (112, 122, 132) based on the response signals and the excitation signals of the corresponding interlinked phase pairs;
wherein the phase switching device (30) comprises a first controllable semiconductor arrangement and is configured, after measurement of a response signal from one interlinked phase pair (113, 123; 113, 133; 123, 133), to switch to another interlinked phase pair,
wherein the evaluation device (50) is configured to determine the network impedance (112, 122, 132) of the non-interlinked phases (111, 121, 131) of the electrical supply network (100) on the basis of the response signals and of the excitation signals of the corresponding interlinked phase pairs,
**characterized in that**
the first controllable semiconductor arrangement of the phase shifting device (30) has a bridge circuit consisting of four TRIACs, each in the form of two antiparallel connected thyristors (30, 37; 30, 38; 30, 39; 30, 40),
wherein a first TRIAC (30, 37) is connected to a first bridge connection point (41),
wherein a second TRIAC (30, 39) is connected to the first bridge connection point (41),
wherein a third TRIAC (30, 38) is connected to a second bridge connection point (42),
wherein a fourth TRIAC (30, 40) is connected to the second bridge connection point (42),
wherein the four-pole output of the bridge circuit formed by the four TRIACS (37, 38, 39, 40) is connected to the electrical supply network (100) by two output nodes (124, 144) of the bridge circuit being connectable to one input node (113, 123) each of the electrical supply network (100), while the other two output nodes of the bridge circuit are combined to form a common output node (134), which is connectable to a third input point (133) of the electrical supply network (100),
wherein the excitation signal generating device (10) consists of two contrary serially arranged second semiconductor arrangements (11, 15),
wherein the excitation signal generating device (10) is arranged between the first bridge connection point (41) and the second bridge connection point (42).

7. Method according to Claim 6, wherein the electrical impulse signal is a random pulse-width modulated signal.

8. Method according to either of Claims 6 and 7, wherein the determination of the network impedance is made on the basis of an analysis of a linear system of equations.

9. Method according to any one of Claims 6 to 8, wherein the load (RL) is substantially a pure resistive load.

10. Method according to any one of Claims 6 to 8, wherein the load (RL) is a coil system.

11. Method according to Claim 10, wherein the coil system is a coil system for magnetic coils with pulsed and identically oriented magnetic field orientation.

## Revendications

1. Dispositif (1) destiné à mesurer l'impédance de réseau d'un réseau d'alimentation électrique (100) sous forme d'un réseau polyphasé, comportant :
un dispositif générateur de signaux d'excitation (10),
une charge (RL),
un dispositif de mesure de signal de réponse (20),
un dispositif de commutation de phase (30),
un dispositif d'évaluation (50);
dans lequel le dispositif générateur de signaux d'excitation (10) est conçu pour émettre un signal d'excitation sur une paire de phases interconnectées (113, 123 ; 113, 133 ; 123, 133) du réseau d'alimentation électrique (100) par l'intermédiaire de la charge (RL),
dans lequel le dispositif de mesure de signal de réponse (20) est conçu pour mesurer un signal de réponse provoqué par le signal d'excitation,
dans lequel le dispositif de commutation de phase (30) comprend un premier agencement pilotable d'éléments semi-conducteurs et est conçu, après la mesure d'un signal de réponse, pour commuter d'une paire de phases interconnectées (113, 123 ; 113, 133 ; 123, 133) sur une autre paire de phases interconnectées,
dans lequel le dispositif d'évaluation (50) est conçu pour déterminer l'impédance de réseau (112, 122, 132) des phases de réseau (111, 121, 131) non interconnectées du réseau d'alimentation électrique (100) sur la base des signaux de réponse et des signaux d'excitation des paires de phase correspondantes interconnectées,
**caractérisé en ce que** le premier agencement pilotable d'éléments semi-conducteurs du dispositif de commutation de phase (30) présente un circuit en pont constitué de quatre triacs sous forme de respectivement deux thyristors (30, 37 ; 30, 38 ; 30, 39 ; 30, 40) montés antiparallèlement,
dans lequel un premier triac (30, 37) est relié à un premier point de connexion de pont (41),
dans lequel un deuxième triac (30, 39) est relié au premier point de connexion de pont (41),
dans lequel un troisième triac (30, 38) est relié à un deuxième point de connexion de pont (42),
dans lequel un quatrième triac (30, 40) est relié au deuxième point de connexion de pont (42),
dans lequel la sortie tétrapolaire du circuit en pont formé à partir des quatre triacs (37, 38, 39, 40) peut être reliée au réseau d'alimentation électrique (100) du fait que deux points de noeud de sortie (124, 144) du circuit en pont peuvent être reliés à respectivement un point d'entrée (113, 123) du réseau d'alimentation électrique (100), alors que les deux autres points de noeud de sortie du circuit en pont sont regroupés en un point de noeud de sortie commun (134), lequel peut être relié à un troisième point d'entrée (133) du réseau d'alimentation électrique (100),
dans lequel le dispositif générateur de signaux d'excitation (10) est constitué de deux deuxièmes agencements pilotables d'éléments semi-conducteurs (11, 15) disposés en série de manière inverse,
dans lequel le dispositif générateur de signaux d'excitation (10) est disposé entre le premier point de connexion de pont (41) et le deuxième point de connexion de pont (42).

2. Dispositif selon la revendication 1, dans lequel le dispositif de commutation de phase (30) et la charge (RL) sont connectés en série.

3. Dispositif selon l'une quelconque des revendications 1 à 2, dans lequel la charge (RL) est une charge essentiellement purement ohmique.

4. Dispositif selon l'une quelconque des revendications 1 à 2, dans lequel la charge (RL) est un système de bobines.

5. Dispositif selon la revendication 4, dans lequel le système de bobines est un système de bobines pour bobines d'excitation à orientation de champ magnétique pulsée et orientée de manière identique.

6. Procédé de mesure de l'impédance de réseau d'un réseau d'alimentation électrique (100) sous forme d'un réseau polyphasé, comprenant :
génération d'un signal d'excitation (S10) pour l'émission sur une paire de phases interconnectées (113, 123 ; 113, 133 ; 123, 133) du réseau d'alimentation électrique (100) par l'intermédiaire d'une charge (RL)
mesure d'un signal de réponse provoqué par le signal d'excitation (S20),
commutation (S30) d'une paire de phases interconnectées (113, 123 ; 113, 133 ; 123, 133) vers une autre paire de phases interconnectées ;
répétition des étapes de génération du signal d'excitation et de mesure du signal de réponse pour chaque paire de phases interconnectées (113, 123 ; 113, 133, 123, 133) ;
détermination de l'impédance de réseau (S50) des phases (112, 122, 132) non interconnectées sur la base des signaux de réponse et des signaux d'excitation des paires de phases correspondantes interconnectées ;
dans lequel le dispositif de commutation de phase (30) comprend un premier agencement pilotable d'éléments semi-conducteurs et est conçu, après la mesure d'un signal de réponse, pour commuter d'une paire de phases interconnectées (113, 123 ; 113, 133 ; 123, 133) sur une autre paire de phases interconnectées,
dans lequel le dispositif d'évaluation (50) est conçu pour déterminer l'impédance de réseau (112, 122, 132) des phases (111, 121, 131) non interconnectées du réseau d'alimentation électrique (100) sur la base des signaux de réponse et des signaux d'excitation des paires de phase correspondantes interconnectées,
**caractérisé en ce que** le premier agencement pilotable d'éléments semi-conducteurs du dispositif de commutation de phase (30) présente un circuit en pont constitué de quatre triacs sous forme de respectivement deux thyristors (30, 37 ; 30, 38 ; 30, 39 ; 30, 40) montés antiparallèlement,
dans lequel un premier triac (30, 37) est relié à un premier point de connexion de pont (41),
dans lequel un deuxième triac (30, 39) est relié au premier point de connexion de pont (41),
dans lequel un troisième triac (30, 38) est relié à un deuxième point de connexion de pont (42),
dans lequel un quatrième triac (30, 40) est relié au deuxième point de connexion de pont (42),
dans lequel la sortie tétrapolaire du circuit en pont formé à partir des quatre triacs (37, 38, 39, 40) peut être reliée au réseau d'alimentation électrique (100) du fait que deux points de noeud de sortie (124, 144) du circuit en pont peuvent être reliés à respectivement un point d'entrée (113, 123) du réseau d'alimentation électrique (100), alors que les deux autres points de noeud de sortie du circuit en pont sont regroupés en un point de noeud de sortie commun (134), lequel peut être relié à un troisième point d'entrée (133) du réseau d'alimentation électrique (100),
dans lequel le dispositif générateur de signaux d'excitation (10) est constitué de deux deuxièmes agencements pilotables d'éléments semi-conducteurs (11, 15) disposés en série de manière inverse,
dans lequel le dispositif générateur de signaux d'excitation (10) est disposé entre le premier point de connexion de pont (41) et le deuxième point de connexion de pont (42).

7. Procédé selon la revendication 6, dans lequel le signal d'impulsion électrique est un signal aléatoire modulé en largeur d'impulsion.

8. Procédé selon l'une quelconque des revendications 6 et 7, dans lequel la détection de l'impédance de réseau est réalisée sur la base d'un système d'équations linéaires.

9. Procédé selon l'une quelconque des revendications 6 à 8, dans lequel la charge (RL) est une charge essentiellement purement ohmique.

10. Procédé selon l'une quelconque des revendications 6 à 8, dans lequel la charge (RL) est un système de bobines.

11. Procédé selon la revendication 10, dans lequel le système de bobines est un système de bobines pour bobines d'excitation à orientation du champ magnétique pulsée et orientée de manière identique.
